Europäisches Patentamt

European Patent Office

Office européen des brevets

(19)

(11) Numéro de publication: **0 378 033**
**A1**

(12) **DEMANDE DE BREVET EUROPEEN**

(21) Numéro de dépôt: **89420517.8**

(22) Date de dépôt: **26.12.89**

(51) Int. Cl.⁵: **G03F 7/20, G03F 7/40**

(30) Priorité: **30.12.88 FR 8817615**

(43) Date de publication de la demande:
**18.07.90 Bulletin 90/29**

(84) Etats contractants désignés:
**AT BE CH DE ES GB IT LI LU NL**

(71) Demandeur: **ETAT FRANCAIS représenté par le Ministre des Postes, Télécommunications et de l'Espace
(CENTRE NATIONAL D'ETUDES DES TELECOMMUNICATIONS) 38-40 rue du Général Leclerc
F-92131 Issy-les-Moulineaux(FR)**

(72) Inventeur: **Tissier, Annie
Domaine des Plantées-Biviers
F-38330 Saint-Ismier(FR)**
Inventeur: **Latombe, Bruno
6, Rue Desnos
F-38400 Saint Martin d'Hères(FR)**
Inventeur: **Poncet, Alain
2, Place Fernand Texier
F-38400 Saint Martin d'Hères(FR)**

(74) Mandataire: **de Beaumont, Michel
1bis, rue Champollion
F-38000 Grenoble(FR)**

(54) **Procédé de détermination de la mise au point d'une machine d'exposition de photolithographie.**

(57) La présente invention concerne un procédé de détermination de la mise au point d'une machine d'exposition photolithographique sur une plaquette revêtue d'une résine, comprenant les étapes suivantes : 1) insoler la résine par un motif de test, successivement en différents emplacements, une mise au point différente étant effectuée pour chaque insolation ; 2) développer la résine ; 3) examiner la plaquette pour déterminer l'insolation optimale et adopter le réglage correspondant pour la machine. Ce procédé comprend en outre, entre les étapes 2) et 3), l'étape consistant à porter la plaquette à une température supérieure à la température de transition vitreuse de la résine.

# PROCEDE DE DETERMINATION DE LA MISE AU POINT D'UNE MACHINE D'EXPOSITION DE PHOTOLITHO-GRAPHIE

La présente invention concerne les machines de fabrication de semiconducteurs et plus particulièrement les machines de photolithographie.

De façon générale, dans le domaine de la fabrication des semiconducteurs, on utilise à de très nombreux stades de fabrication de circuits intégrés des étapes de photolithogravure.

Une étape de photolithogravure se décompose classiquement en les étapes suivantes :
- dépôt sur un substrat de la couche mince que l'on veut graver pour en laisser demeurer des parties,
- dépôt sur cette couche mince d'une couche de masquage photosensible, couramment appelée résine photosensible,
- insolation de la couche de masquage selon le motif choisi,
- développement de la couche de masquage pour laisser en place les seules parties insolées (résine positive) ou non-insolées (résine négative), correspondant aux emplacements de la couche mince que l'on veut laisser en place, et
- gravure de la couche mince aux endroits non-protégés par la couche de masquage.

Egalement, dans le domaine des semiconducteurs, de nombreux procédés ont été développés pour la gravure des couches minces. Parmi ces procédés, on peut citer les procédés de gravure humide (dans un bain d'attaque) et les procédés de gravure sèche (en présence d'un plasma) ainsi que les procédés de gravure anisotrope et les procédés de gravure isotrope.

Quel que soit le procédé de gravure, une des étapes clé de ce processus réside dans l'étape d'insolation de la couche de résine, qui peut être effectuée par divers appareils connus, par exemple un photorépéteur. En effet, si l'image du masque que l'on veut former sur la couche de résine n'est pas convenablement au point (mise au point trop courte) ou que la dose d'insolation est insuffisante, on risque de ne pas impressionner suffisamment la résine photosensible qui demeurera partiellement en place après développement dans des zones d'où elle aurait due être enlevée. Inversement, si l'insolation est excessive, ou que la profondeur de mise au point est trop grande, la résine sera impressionnée de façon excessive et, lors du développement de la résine, les cotes obtenus seront supérieures ou inférieures (résine positive ou négative) aux cotes recherchés. Dans le cadre des technologies modernes ou l'on cherche à définir des traits d'une largeur de l'ordre du micromètre, cette étape de mise au point est particulièrement critique et les variations de température ou d'hygrométrie de la pièce dans lequel se trouve la machine d'exposition entraînent des modifications éventuelles de réglages de cette machine. Ceci nécessite donc un reréglage périodique, couramment au moins une fois par jour dans une chaîne de fabrication.

De façon classique, pour effectuer ce réglage, on projette sur une plaquette test, de façon répétitive et successive, un même motif de test en différents emplacements de la plaquette, ces emplacements correspondant par exemple aux divers emplacements de puces que l'on veut former sur la plaquette lors du processus de fabrication normal. Pour chaque emplacement sur lequel on pro jette le motif, on fait varier la mise au point de la machine d'exposition d'une valeur très faible par rapport à la valeur moyenne. Ensuite, après développement de la résine, on observe sous microscope à fort grossissement (500 à 1000), chacun des motifs pour sélectionner celui qui correspond à la résolution optimale, c'est-à-dire le premier motif pour lequel la résine est complètement éliminée aux emplacements souhaités, sans qu'il ait surgravure de la résine. Cette opération est pénible pour l'opérateur car la profondeur de champ du microscope est inférieure à l'épaisseur de la résine (par exemple de l'ordre du micromètre pour l'épaisseur totale de la couche) et d'autre part imprécise car elle dépend de l'interprétation que peut en faire l'opérateur. On peut bien sûr améliorer la précision en utilisant un microscope électronique à balayage mais il en résulte un allongement du temps de mesure et de son coût.

Ainsi, un objet de la présente invention est de prévoir un procédé permettant de faciliter cette mise au point et de plus de la rendre facilement automatisable.

Cet objet est atteint en prévoyant, dans le cadre général du procédé de l'art antérieur décrit ci-dessus, de faire fluer la résine en la chauffant au-dessus de sa température de transition vitreuse après développement et avant observation. Il en résulte comme on le verra ci-après que le contraste est considérablement augmenté dans le cas où la résine a été complètement éliminée des emplacements souhaités par rapport au cas où elle demeure au moins partiellement en place dans ces emplacements.

Ces objets, caractéristiques et avantages ainsi que d'autres de la présente invention seront exposés plus en détail dans la description suivante d'un mode de réalisation particulier faite en relation avec les figures jointes parmi lesquelles :

la figure 1 représente une plaquette revêtue d'une couche de résine, insolée par des motifs de test, après développement de la résine ; et

la figure 2 représente cette même plaquette après réalisation d'une étape de fluage selon la présente invention.

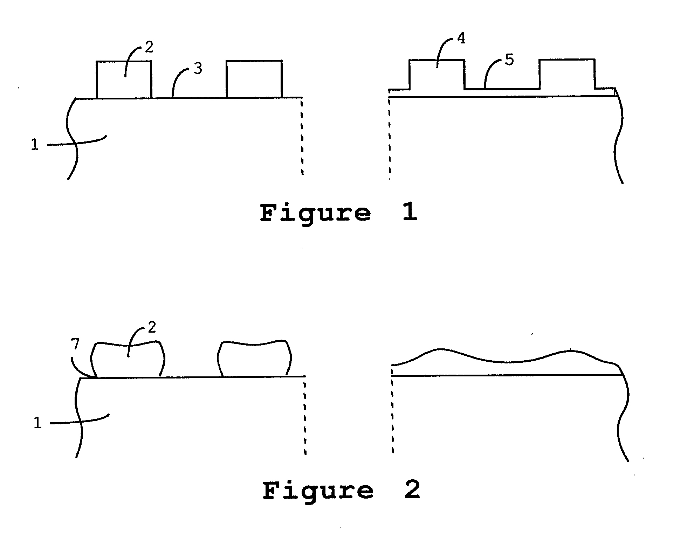

La figure 1 représente à titre d'exemple, une couche de résine, par exemple une couche polymère novolaque, formée sur un substrat 1, par exemple un substrat de silicium. La couche de résine a subi le traitement classique d'exposition à un motif de test, par exemple en forme de bande, et de développement. A la partie gauche de la figure, on peut voir en coupe une région correspondant à une insolation optimale dans laquelle il demeure des bandes de résine 2 entre lesquelles apparaît la surface 3 du substrat de silicium. A la partie droite de la figure, la résine a été insuffisamment insolée et l'on trouve entre des bandes 4 de résine des régions où demeure une couche mince de résine 5. Cette couche peut d'ailleurs être d'épaisseur inégale et laisser partiellement apparaître la surface du substrat de silicium. Pour donner des ordres de grandeur, l'épaisseur de la couche de résine au niveau des bandes peut être de l'ordre du micromètre, et les bandes peuvent être réalisées à un pas de 1 à 3 micromètres. Quant à l'épaisseur de la couche 5, elle est extrêmement faible puisqu'elle résulte du dernier réglage proche du réglage optimal. Il en résulte, comme on l'a indiqué précédemment, que cette couche 5 est très peu visible pour un observateur et, en raison de sa très faible épaisseur devant une longueur d'onde optique, difficilement décelable par réflectométrie par rapport au cas où elle est absente.

Ainsi, le procédé selon la présente invention propose comme le montre la figure 2 de soumettre la plaquette à une étape thermique à une température supérieure à la température de fluage (ou température de transition vitreuse) de la résine utilisée, par exemple, pour une résine Kodak KTI 820 une température de l'ordre de 100 à 110° pendant quelques dizaines de secondes. On s'aperçoit alors que, dans le cas où la résine a complètement été éliminée entre les bandes 2, l'allure de ces bandes se déforme mais il existe un point d'encrage 7 à l'interface résine-substrat et la résine ne tend pas à fluer d'une bande à l'autre. C'est ce qui est représenté dans la partie gauche de la figure 2. Par contre, comme le représente la partie droite de la figure 2, dès qu'une mince couche de résine 5 existe entre les bandes 4, le fluage entraîne son comblement de la région intermédiaire pour arriver à un profil plus ou moins largement ondulé selon la durée et la température du recuit.

Ainsi, comme le comprendra l'homme de l'art, après cette étape de fluage, la différenciation entre le cas représenté à gauche de la figure et celui représenté à droite devient extrêmement facile. On pourra par exemple utiliser un microscope optique de grossissement moyen (100 à 200) : on détermine la zone de mise au point comme étant la première des zones comportant des bandes ou trous de contact très nettement visibles alors que les bandes ou trous de contact ont disparu dans toutes les zones insuffisamment insolées.

D'une façon plus automatique, on pourra procéder par réflectométrie optique ce qui permet ensuite de prévoir une automatisation complète du réglage. Une structure telle que celle représentée à la gauche de la figure 2 présente un coefficient de réflexion d'ensemble (il faut comprendre que de nombreuses bandes parallèles sont prévues dans le motif) par rapport au motif représenté à la droite de la figure 2. Par exemple, dans le cas d'un substrat de silicium indiqué précédemment, le pouvoir réflecteur de silicium nu est très supérieur à celui du silicium revêtu de résine. L'intensité lumineuse sera donc beaucoup plus forte dans le cas de la partie gauche de la figure que dans celui de la partie droite.

On notera que le procédé selon la présente invention est particulièrement simple, n'entraîne la nécessité d'aucun équipement coûteux et prend peu de temps. En effet, comme l'indique l'exemple précédent, le recuit peut être effectué pendant une durée très courte (quelques dizaines de secondes seulement) et fournir un résultat satisfaisant. D'autre part, la température de recuit n'est pas critique.

Bien entendu, la présente invention est susceptible de nombreuses variantes qui apparaîtront à l'homme de l'art. On a exposé ci-dessus l'exemple d'une plaquette de silicium revêtue d'une couche de résine. Il pourra s'agir d'un autre substrat adapté au processus que l'on cherche à mettre en oeuvre dans une fabrication réelle. Par exemple, le substrat pourra comporter une couche supérieure d'oxyde de silicium, de métal, de nitrure de silicium, de polysiliciure métallique, etc.

D'autre part, on a indiqué ci-dessus que le procédé était mis en oeuvre sur une plaquette test. On pourra également le mettre en oeuvre en utilisant une plaquette réelle d'un lot de plaquettes à traiter.

## Revendications

1. Procédé de détermination de la mise au point d'une machine d'exposition photolithographique sur une plaquette revêtue d'une résine, comprenant les étapes suivantes :

1) insoler la résine par un motif de test, successivement en différents emplacements, une mise au point différente étant effectuée pour chaque insolation,

2) développer la résine,

3) examiner la plaquette pour déterminer l'insolation optimale et adopter le réglage correspondant pour la machine, caractérisé en ce qu'il comprend en outre, entre les étapes 2) et 3), l'étape consistant à porter la plaquette à une température supérieure à la température de transition vitreuse de la résine.

2. Procédé selon la revendication 1, caractérisé en ce que l'étape d'examen est réalisée par réflectométrie optique.

3. Procédé selon la revendication 1, caractérisé en ce que les mises au point différentes correspondent à des réglages incrémentiels de la mise au point autour d'un réglage moyen.

4. Procédé selon la revendication 1, caractérisé en ce que la résine est une résine novolaque.

Figure 1

Figure 2

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.5 ) |
|---|---|---|---|
| A | EP-A-217463 (N.V.PHILIPS'GLOEILAMPENFABRIEKEN) <br> * le document en entier * <br> --- | 1 | G03F7/20 <br> G03F7/40 |
| A | PHOTOGRAPHIC SCIENCE AND ENGINEERING. <br> vol. 21, no. 5, septembre 1977, WASHINGTON US <br> pages 290 - 292; Kiyokatsu Jinno et.al.: <br> "Baking Characteristics of Positive Resists" <br> * le document en entier * <br> ----- | 1 | |

**DOMAINES TECHNIQUES RECHERCHES (Int. Cl.5 )**

G03F

Le présent rapport a été établi pour toutes les revendications

| Lieu de la recherche | Date d'achèvement de la recherche | Examinateur |
|---|---|---|
| LA HAYE | 11 AVRIL 1990 | RASSCHAERT A. |

EPO FORM 1503 03.82 (P0402)